# EUROPEAN PATENT SPECIFICATION

(11) **EP 2 868 767 B1**
(45) Date of publication and mention of the grant of the patent: **07.08.2019**
(21) Application number: 13810005.2
(22) Date of filing: 19.06.2013
(51) Int. Cl.: B05D 3/06, B05D 1/00, C23C 14/22, C23C 14/56, C23C 14/12, C23C 14/58, H01J 37/32

(54) **ORGANIC THIN FILM FORMATION DEVICE**
VORRICHTUNG ZUR BILDUNG ORGANISCHER DÜNNSCHICHTEN
DISPOSITIF DE FORMATION D'UN FILM MINCE ORGANIQUE

(30) Priority: 29.06.2012 JP 2012147691
(43) Date of publication of application: 06.05.2015
(73) Proprietor: ULVAC, Inc., Chigasaki-shi, Kanagawa 253-8543 (JP)
(72) Inventor: SAITOU, Kazuhiko, Chigasaki-shi Kanagawa 253-8543 (JP); IIJIMA, Masayuki, Chigasaki-shi Kanagawa 253-8543 (JP); HIRONO, Takayoshi, Chigasaki-shi Kanagawa 253-8543 (JP); NAKAMORI, Kenji, Chigasaki-shi Kanagawa 253-8543 (JP)
(74) Representative: Körber, Martin Hans
(86) International application number: PCT/JP2013/066804
(87) International publication number: WO 2014/002842

(56) References cited:
- JP-A- H09 310 172
- JP-A- H11 323 532
- JP-A- H11 323 532
- JP-A- 2006 037 131
- JP-A- 2010 189 683
- US-A1- 2010 261 017
- US-A1- 2011 052 891

## Description

### Technical Field

The present invention generally relates to an organic thin film formation device, in particular, to an organic thin film formation device for forming an organic thin film on a film in a vacuum atmosphere .

### Background Art

A thin film formation device that forms an organic thin film on a film in a vacuum atmosphere has been used conventionally; and a film for food packing or a film for electronic parts is produced by formation of a metal thin film or an organic thin film on a film.

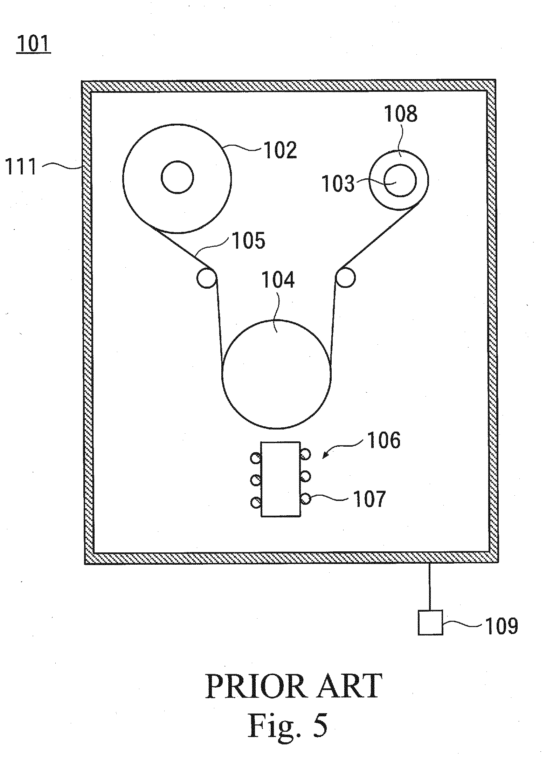

The device is shown in Fig. 5. An organic thin film formation device 101 has a vacuum chamber 111; and, in the vacuum chamber 111, an original material roll 102 obtained by winding a base material film 105 to be film formed and a winding device 103 that winds up the base material film 105 unwound from the original material roll 102 are disposed.

In order to form an organic thin film on the base material film 105, first, the base material film 105 is unwound from the original material roll 102, and the leading edge of the unwound portion is attached to the winding device 103, whereby the rear surface of the base material film 105 is made to contact a part of the side surface of a center roller 104 disposed in the center of the vacuum chamber 111.

The interior of the vacuum chamber 111 is evacuated by a vacuum pump 109; the center roller 104 is rotated so that the base material film 105 and the surface of the center roller 104 do not slide each other; the base material film 105 is unwound from the original material roll 102; and the unwound base material film 105 is wound by the winding device 103.

A vapor production device 106 is disposed in a position facing the portion where the center roller 104 and the base material film 105 are in contact with each other; and when heating an organic material disposed in the vapor production device 106 by a heating device 107, vapor of the organic material is produced in the vapor production device 106 and the vapor of the organic material is discharged from a discharge port of the vapor production device 106 toward the center roller 104. In the position facing the discharge port, the base material film 105 moves while making contact with the center roller 104, the vapor of the organic material reaches the surface of the base material film 105 during movement in the position facing the discharge port, and an organic thin film is formed on the surface thereof, which is wound by the winding device 103 to thereby give a wound roll 108.

However, in the above-described organic thin film formation device 101, curing of the organic material is insufficient, and a technology for accelerating the curing reaction before the winding is required.

Furthermore, the technology is needed to have the thickness of the organic thin film formed on the base material film 105 be uniform and the interior of the vacuum chamber 111 be not polluted by the organic material vapor discharged inside the vacuum chamber 111.

Another thin film technology is disclosed in JPH11323532A, which relates to the production process of a resin thin film by evaporating and depositing resin material on a support surface. The main components of the coating system 100 of JPH11323532A are a vacuum chamber 101, separated into two spaces by a partition wall 130 and 131: an upper space (second space) 150 that includes a roll 121 and the take-up roll 125 unwinding providing about 5 of 5 × 10⁻⁴ Torr generated by a vacuum pump 151, and a lower space 250 containing a resin thin film forming apparatus 200, providing about 2 × 10⁻⁴ Torr generated by another vacuum pump 251.

A further thin film technology is disclosed in US2011/052891A1 which relates to a gas barrier film for use in displays. More specifically US2011/052891A1 relates to a gas barrier film having organic layers and one or more inorganic layers stacked on a surface of a flexible film and capable of being produced with high efficiency and a method of producing the gas barrier film.
[Patent Literature 1] Published Japanese translation of PCT patent application No. 2000-508089
[Patent Literature 2] Japanese Patent Laid-Open No. 2010-236076
[Patent Literature 3] Japanese Patent No. 3502261

### Disclosure of the Invention

### Problems to be Solved by the Invention

The present invention has been created in order to solve the disadvantage of the conventional technology, and a purpose thereof is to provide such an organic thin film formation device that does not pollute the interior of a vacuum chamber by the vapor, and forms a cured organic thin film at a high film formation rate.

### Means for Solving the Problems

In order to solve the above-described problem, the present invention is a thin film formation device which includes a vacuum chamber, a vapor discharge device, an energy ray-emitting device, an unwinding device, a winding device and a cylindrical center roller, and in which an original material roll of a base material film mounted on the unwinding device is unwound, during a time when the unwound base material film runs in the vacuum chamber while the rear surface thereof is in contact with the side surface of the center roller and is wound by the winding device, vapor of an organic compound discharged from a discharge port of the vapor discharge device into the vacuum chamber reaches the surface of the base material film in a portion in contact with the side surface of the center roller to thereby deposit an organic raw material layer, then the organic raw material layer is irradiated with an energy ray emitted from an emission part of the energy ray-emitting device, and the organic compound in the organic raw material layer chemically reacts to thereby form an organic thin film, wherein a configuration is such that: a vapor generation device generating vapor of the organic compound and supplying the vapor to the vapor discharge device is disposed in the exterior of the vacuum chamber; a buffer chamber is disposed in the interior of the vacuum chamber; a curing chamber is disposed in the interior of the vacuum chamber and in the exterior of the buffer chamber; the curing chamber is separated from the other section of the interior space of the buffer chamber by a curing chamber partition wall, wherein the other section of the interior space of the buffer chamber is arranged between the curing chamber and the roll chamber.

A film formation chamber is disposed in the interior of the buffer chamber; each of the buffer chamber, the film formation chamber and the curing chamber is connected to an evacuation device; the discharge port is disposed in the interior of the film formation chamber; the emission part is disposed in the curing chamber; the center roller is disposed so as to rotate around a rotation axis line positioned in the buffer chamber; a film formation chamber opening is provided in a portion positioned between the rotation axis line and the discharge port in a film formation chamber partition wall forming the film formation chamber and the discharge port and a side surface of the center roller face each other; and a curing chamber opening is provided in a portion positioned between the rotation axis line and the emission part in a curing chamber partition wall forming the curing chamber, and the emission part and a side surface of the center roller face each other.

In addition, the present invention is a thin film formation device configured so that a cooling device is connected to the center roller and the cooling device circulates a cooling medium between the center roller and the cooling device to thereby cool the center roller.

Furthermore, the present invention is a thin film formation device, wherein a portion of a side surface of the center roller, facing the discharge port is inserted into the interior of the film formation chamber from the film formation chamber opening, and a portion of a side wall of the center roller, facing the emission part is inserted into the interior of the curing chamber from the curing chamber opening.

Moreover, the present invention is a thin film formation device, further including a carrier gas supply device for supplying a carrier gas to the vapor generation device, wherein a mixed gas obtained by mixing the carrier gas and vapor of the organic compound is discharged from the discharge port.

In addition, the present invention is a thin film formation device, which is evacuated by the evacuation device so that the pressure of the film formation chamber is made higher than pressure of the buffer chamber, and that the pressure of the curing chamber is made lower than the buffer chamber.

### Effect of the Invention

In the present invention, since a vapor generation chamber is disposed in the exterior of a vacuum chamber and an opening of the film formation chamber is disposed in the interior of the buffer chamber, replenishment of an organic compound is easy and the vapor generated from the organic compound does not flow into the curing chamber or the roll chamber.

Since the center roller is cooled to the vapor condensation temperature or less, the vapor of an organic compound formed by heating can be condensed (solidification of gas is assumed to be included in addition to liquefaction of gas) ; and since the organic raw material layer formed by the condensation is cured with the energy resin, a tough organic thin film can be obtained.

Furthermore, the generated vapor is carried by a carrier gas; and thus, a large amount of vapor can be supplied to the film formation chamber from the vapor generation chamber and a film formation rate can be accelerated.

Moreover, since the formation of the organic raw material layer and the curing of the organic raw material layer are performed by one center roller, the volume of the vacuum chamber can be reduced.

### Brief Description of the Drawings

Fig. 1 is a drawing for explaining the thin film formation device of the present invention.
Fig. 2 (a) and Fig. 2 (b) are drawings for explaining a discharge port.
Fig. 3(a) is a drawing for explaining an opening of a film formation chamber; and Fig. 3(b) is a drawing for explaining an opening of a curing chamber.
Fig. 4 (a) is a drawing showing a state where an organic raw material layer is formed on a base material film; and Fig. 4(b) is a drawing showing a state where an organic thin film of polymer is formed from the organic raw material layer.
Fig. 5 is a thin film formation device of a conventional technology.

### Preferred embodiment of the invention

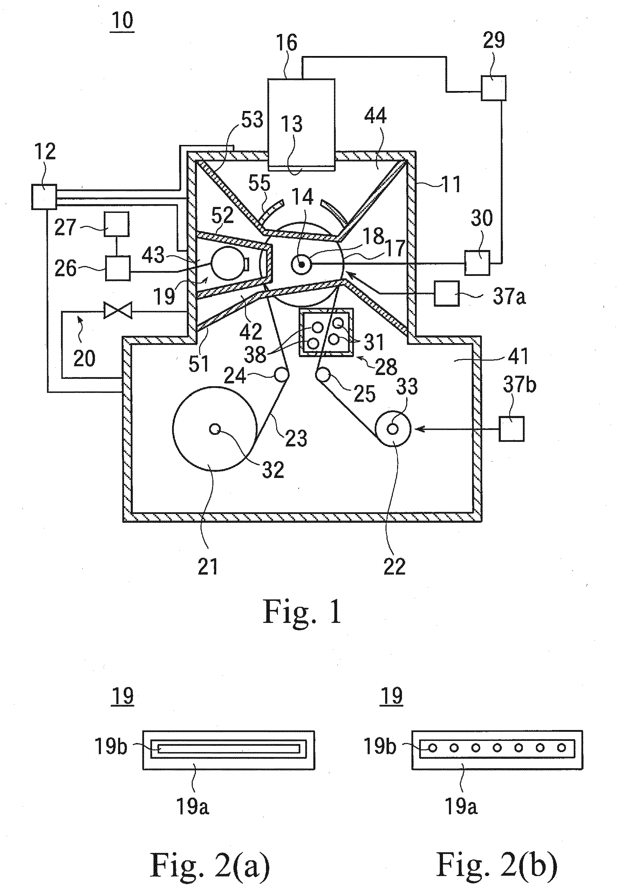

Fig. 1 shows a thin film formation device 10 of the present invention.

The thin film formation device 10 has a vacuum chamber 11; the interior of the vacuum chamber 11 is partitioned by a partition plate 51; and a roll chamber 41 is formed on one side of the partition plate 51 in the interior of the vacuum chamber 11.

A buffer chamber 42 is formed on the opposite side of the partition plate 51. A film formation chamber partition wall 52 is disposed in the interior of the buffer chamber 42; and a film formation chamber 43 separated from the interior space of the buffer chamber 42 is formed by the film formation chamber partition wall 52. The numeral 20 is a valve for pressure control between the roll chamber 41 and the buffer chamber 42.

Furthermore, a curing chamber partition wall 53 is disposed in a position separated from the film formation chamber 43 in the interior of the buffer chamber 42; and a curing chamber 44 separated from the interior space of the buffer chamber 42 is formed in the interior of the buffer chamber 42, by the curing chamber partition wall 53. The film formation chamber 43 and the curing chamber 44 are also separated from each other.

A center roller 17 that is constituted of a metal and has a cylindrical shape is disposed in the interior of the buffer chamber 42. Here, a rotation shaft 18 is disposed horizontally in the interior of the buffer chamber 42, and is configured such that the center roller 17 is attached to the rotation shaft 18 by making the central axis line thereof and the central axis line of the rotation shaft 18 coincide with each other, and such that the rotation shaft 18 and the center roller 17 rotate together around the coincident central axis line. Reference numeral 14 in Fig. 1 is the rotation axis line serving as the rotation center of the rotation shaft 18 and the center roller 17 and is also the central axis line of the rotation shaft 18 and the center roller 17.

The roll chamber 41, the film formation chamber 43 and the curing chamber 44 are disposed around the side surface of the center roller 17.

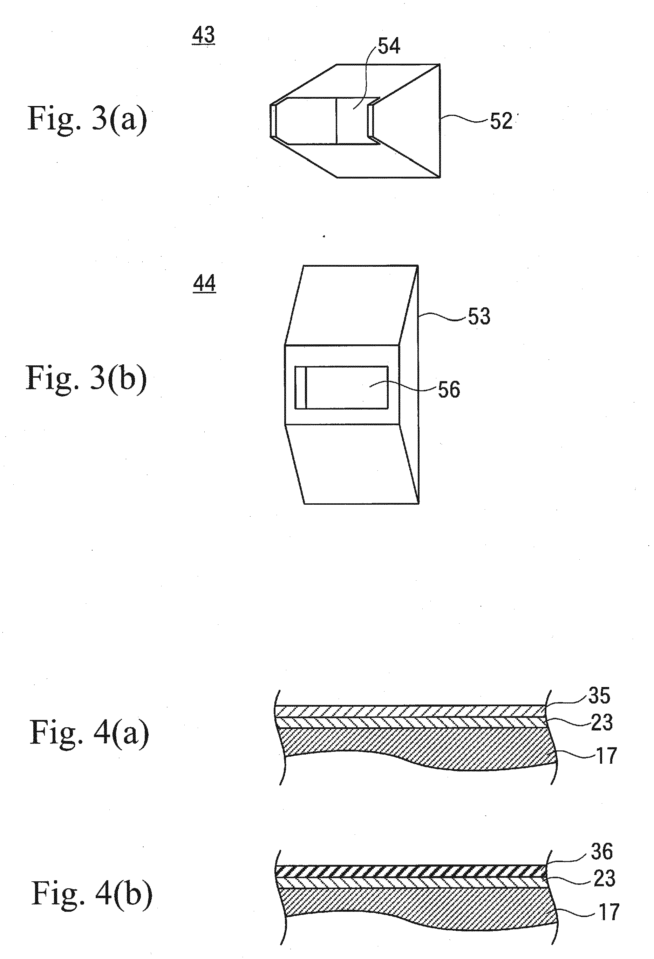

As shown in Fig. 3(a), a film formation chamber opening 54 is formed in the film formation chamber partition wall 52; and as shown in Fig. 3(b), a curing chamber opening 56 is formed in the curing chamber partition wall 53.

Each of the width of the film formation chamber opening 54, the width of the curing chamber opening 56 and the width of a passing port to be described below is set to be a little larger than the width of the side surface of the center roller 17 (distance between bottom faces). As to the side surface of the center roller 17, a part of the circumferential direction (that is, the whole part of the width direction thereof) is inserted in the film formation chamber 43, and another part of the circumferential direction of the side surface of the central roller 17 (that is, the whole part of the width direction thereof) is inserted in the curing chamber 44. The side surfaces of the inserted parts are exposed in the interior of the film formation chamber 43 and the curing chamber 44.

An unwinding device 32 and a winding device 33 are disposed in the interior of the roll chamber 41.

An original material roll 21 configured by winding a base material film 23 of a long sheet to be film-formed is mounted on the unwinding device 32, and first, the end portion of the base material film 23 positioned in the periphery of the original material roll 21 is extracted for winding the base material film 23 of the original material roll 21 by the winding device 33.

A passing port is formed in the partition plate 51. The top of the extracted portion passes through the passing port, then the direction thereof is changed by a roll 24, and is carried in the interior of the buffer chamber 42, comes into contact with the side surface of the center roller 17, moves along the circumferential direction of the side surface, passes through the interior of the film formation chamber 43, the interior of the buffer chamber 42, the interior of the curing chamber 44 and the interior of the buffer chamber 42, is returned to the roll chamber 41, then the direction thereof is changed by a roll 25, and is fixed to the winding device 33.

The center roller 17 is set so as not to contact the partition plate 51, the film formation chamber partition wall 52 and the curing chamber partition wall 53.

Motors 37a and 37b are provided respectively at the rotation shaft 18 and the winding device 33.

The unwinding device 32 is rotatably configured; and when the rotation shaft 18 and center roller 17, and the winding device 33 are rotated respectively by the motors 37a and 37b, the original material roll 21 is pulled by the unwound base material film 23 and is rotated together with the unwinding device 32, and the base material film 23 is further unwound from the original material roll 21. The unwound portion is wound by the winding device 33 so that no slack is generated in the base material film 23.

When forming an organic thin film on the surface of the base material film 23, first, the interior of the vacuum chamber 11 is evacuated by the evacuation device 12.

The evacuation device 12 is connected individually to the roll chamber 41, the buffer chamber 42, the film formation chamber 43, and the curing chamber 44; and thus, each of chambers 41 to 44 is set to be capable of being individually evacuated.

Furthermore, each of chambers 41 to 44 is continuously evacuated after the formation of a vacuum atmosphere in each of chambers 41 to 44; and in the explanation below, a vacuum atmosphere is formed in each of chambers 41 to 44 and the evacuation is assumed to be continuously performed.

A vapor discharge device 19 is disposed in the interior of the film formation chamber 43.

A vapor generation device 26 is disposed in the exterior of the vacuum chamber 11; and the vapor discharge device 19 is connected to the vapor generation device 26.

The vapor generation device 26 has a heating device and a vessel in which a liquid or solid organic compound is disposed, and is configured so as to heat little by little the organic compound disposed in the vessel by a heating device to thereby generate vapor.

Here, the organic compound is evaporated or sublimated by the heating to thereby produce a gas. In the present invention, the gas produced by the sublimation is assumed to be included in "vapor."

A carrier gas supply device 27 that supplies a carrier gas (a gas that does not react with an organic compound such as rare gases and N₂ gas) is disposed to the vapor generation device 26, which is configured so as to be capable of supplying a carrier gas that is heated and raised to a prescribed temperature from the carrier gas supply device 27 to the interior of the vapor generation device 26.

The vapor of an organic compound is generated in the interior of the vapor generation device 26 while the carrier gas is being supplied, and the mixing of the generated vapor with the carrier gas produces a mixed gas and the mixed gas is carried to the vapor discharge device 19 by the difference in pressures between the vapor discharge device 19 and the vapor generation device 26.

An example of the vapor discharge device is shown in Fig. 2 (a) .

The vapor discharge device 19 has a discharge device main body 19a with a hollow interior and a long and narrow discharge port 19b provided in the discharge device main body 19a. The mixed gas of a vapor and a carrier gas supplied from the vapor discharge device 19 spreads uniformly in the discharge device main body 19a, and is uniformly discharged inside the film formation chamber 43 from the discharge port 19b.

The discharge port 19b is disposed in a position facing the side surface of the center roller 17 in a state where the longitudinal direction is in parallel with the rotation axis line 14; and the base material film 23 is positioned between the discharge port 19b and the center roller 17.

The length of the discharge port 19b in the longitudinal direction is set to be longer than the width of the base material film 23; and thus, both ends of the discharge port 19b protrude to the outside of the width direction of the base material film 23.

When vapor is discharged from the discharge port 19b together with a carrier gas, the vapor reaches the range including both ends of the width direction of the base material film 23.

As shown in Fig. 2(b), the discharge port 19b of a circular opening may also be arranged in one line or a plurality of lines in parallel with the width direction of the base material film 23 in a range longer than the width of the base material film 23.

In a part facing the discharge port 19b in the side surface of the center roller 17, the rear surface of the base material film 23 positioned between the center roller 17 and the discharge port 19b is in contact with the side surface of the center roller 17, and the vapor discharged from the discharge port 19b reaches the part in which the rear surface is in contact with the center roller 17, on the base material film 23.

Respective portions of the surface of the base material film 23 is in contact with the center roller 17 before being moved to a position where the vapor discharged from the discharge port 19b reaches and is cooled by the center roller 17, as will be described later; and the temperature of the cooled base material film 23 is set to be a temperature at which the partial pressure of the vapor near the surface of the base material film 23 of a portion where the vapor reaches becomes higher than the saturated vapor pressure by the interior pressure of the film formation chamber 43.

Accordingly, the vapor that reaches the surface of the base material film 23 condenses into a liquid or gas; and an organic raw material layer composed of the vapor condensed on the surface of the base material film 23 is deposited. Fig. 4(a) shows a state where an organic raw material layer 35 is deposited on the base material film 23.

An organic compound of a monomer is disposed within the vapor generation device 26, and the vapor thereof is a gaseous monomer. Accordingly, the organic raw material layer 35 is a monomer layer composed of the monomer.

As to the base material film 23, after being fed out from the original material roll 21 and before the deposition of the organic raw material layer 35, the rear surface is in contact with the center roller 17; and as described above, when the center roller 17 and the winding device 33 rotate to thereby move the base material film 23, the center roller 17 and the winding device 33 rotate so as to move the base material film 23 without the scratch of the rear surface, in a state where the rear surface is in contact with the side surface of the center roller 17.

The base material film 23 on which the organic raw material layer 35 has been deposited is carried out from the film formation chamber 43 in a state where the rear surface is in contact with the center roller 17, passes through the buffer chamber 42 and, after that, is carried into the interior of the curing chamber 44.

The curing chamber 44 is provided with an energy ray-emitting device 16.

The energy ray-emitting device 16 has an emission part 13; and is configured such that emission part 13 is disposed in the curing chamber 44 and an energy ray is emitted from the emission part 13 to the interior of the curing chamber 44.

The organic raw material layer 35 on the surface of the base material film 23 that is in contact with the side surface of the center roller 17 inserted in the interior of the curing chamber 44 is irradiated with the emitted energy ray.

The range of the base material film 23 irradiated with the energy ray is in the shape of a straight line along the width direction of the base material film 23 (that is, is in the shape of a straight line extending in the direction perpendicular to the moving direction of the base material film 23) ; and the base material film 23 is irradiated over a range wider than that in the width direction. The width of the irradiation range is constant; and the organic raw material layer 35 is irradiated with the width of the energy ray in the whole position in the width direction, when passing through the irradiation position.

In the portions of the organic raw material layer 35 having been irradiated with the energy ray, a polymerization reaction of monomers is generated by the energy the energy ray has, the monomer is made into a polymer by the progress of the polymerization reaction, and thus an organic thin film of polymer from the organic raw material layer 35 is formed. Reference numeral 36 in Fig. 4 (b) shows the organic thin film.

Here, the energy ray includes electrons, but may be a ray that radiates another elemental particle or charged particle, or radiates an electromagnetic wave (including light).

However, when an energy ray has an electric charge, an irradiated base material film 23 is charged. In the present invention, the center roller 17 is connected to the ground potential, and is thus configured such that electric charges to be accumulated on the organic thin film 36 or the base material film 23 by the irradiation with the energy ray flow out from the center roller 17 to the ground potential to thereby reduce the charges.

A cooling device 30 is provided to the center roller 17, and the cooling device 30 is configured so as to circulate a cooling medium between the cooling device 30 and the center roller 17, and to cause the cooled cooling medium to flow into a flow path in the interior of the center roller 17 to thereby cool the center roller 17.

The rear surface of the base material film 23 is in contact with the portion inserted in the interior of the film formation chamber 43 in the side surface of the center roller 17 in the interior of the film formation chamber 43 and in contact with the portion inserted in the interior of the curing chamber 44 in the interior of the curing chamber 44; and the rear surface of the base material film 23 is in contact with the identical center roller 17 during the time from before the formation of the organic raw material layer 35 until after the formation of the organic thin film 36. During such time, the base material film 23 is cooled by the center roller 17 and moves while being cooled.

The heat caused by the vapor reached the base material film 23 or by the energy ray with which the base material film 23 and the organic raw material layer 35 have been irradiated raises the temperature of the cooling medium flowing through the flow path of the center roller 17 and the cooling medium having a raised temperature is returned to the cooling device 30.

In the cooling device 30, the heat of the cooling medium is released to be cooled, and the cooled cooling medium is carried to be circulated into the center roller 17.

It is sufficient that the base material film 23 makes contact with the center roller 17 and cooled to a temperature for condensation before condensing the vapor of an organic compound; and the position in which the contact is started may be any position of the interior of the roll chamber 41, the interior of the buffer chamber 42, and the interior of the film formation chamber 43.

The base material film 23 of the portion in which the organic thin film 36 is formed passes through the curing chamber opening 56 while the rear surface thereof is in contact with the center roller 17, is carried out from the curing chamber 44, is carried into the buffer chamber 42, passes through the buffer chamber 42, passes through the passing port formed in the partition plate 51, and is carried into the roll chamber 41.

When a charged particle (such as, an electron) is emitted toward the base material film 23, the base material film 23 becomes charged, and the base material film 23 may be adsorbed to the center roller 17 by the electrostatic force of the charge when the base material film 23 is separated from the center roller 17, and the base material film 23 may be caught in the center roller 17 due to failure in the separation.

In the present invention, since a neutralization device 28 is provided in the vicinity of a positon in which the base material film 23 is separated from the center roller 17, plasma formed by the neutralization device 28 is spread over a separation position and thus, the charged amount before the separation is decreased.

The separation position should be disposed in a chamber in which the neutralization device 28 is disposed, which in this case is the roll chamber 41.

After being separated from the center roller 17 in the roll chamber 41, the base material film 23 of the portion in which the organic thin film 36 is formed passes through plasma formed by the neutralization device 28 to be neutralized, and is wound up by the winding device 33. Accordingly, the base material film 23 on which the organic thin film 36 is formed is not charged, and the winding device 33 having wound the same is also not charged and there is no adsorption of the base material film 23 caused by the charging.

As described above, the vapor of the monomer discharged from the vapor discharge device 19 adheres to the base material film 23 by condensation and the organic raw material layer 35 is formed. Furthermore, the organic raw material layer 35 is cured and formed into the organic thin film 36 by the generation of a polymerization reaction through irradiation of the organic raw material layer 35 with an energy ray. During such time, the rear surface of the base material film 23 is in contact with the identical center roller 17, and the base material film 23 on which the organic thin film 36 is formed can be obtained with one center roller 17. In this case, after the base material film 23 has come into contact with the center roller 17, the base material film 23 and the center roller 17 are not separated during the period when they are separated after the formation of the organic thin film 36.

As to the vacuum atmosphere of the film formation chamber 43, the film formation chamber 43 is disposed in the interior of the buffer chamber 42, and the interior of the buffer chamber 42 and the interior of the film formation chamber 43 is separated from each other by the film formation chamber partition wall 52 and the tank wall of the vacuum chamber 11. The interior of the buffer chamber 42 and the interior of the film formation chamber 43 are connected to each other only by the film formation chamber opening 54, and portions other than the film formation chamber opening 54 are shielded.

The vacuum atmosphere of the curing chamber 44 is connected to the vacuum atmosphere of the buffer chamber 42 by the curing chamber opening 56; and the vacuum atmosphere of the roll chamber 41 is connected to the vacuum atmosphere of the buffer chamber 42 by the passing port of the partition plate 51. However, the film formation chamber opening 54 is disposed in the interior of the buffer chamber 42, and it is configured such that the vapor and the carrier gas that flow out from the film formation chamber opening 54 are evacuated by the evacuation device 12 that evacuates the buffer chamber 42 so as to prevent the vapor and the carrier gas from flowing into the curing chamber 44 and the roll chamber 41.

When a member that controls all the devices provided in the film formation chamber 43 of the present invention is referred to as a control device 29, the individual evacuation rate of each of chambers 41 to 44 of the evacuation device 12 and the supply amount of the carrier gas to the vapor generation device 26 are controlled by the control device 29. Furthermore, with the use of the control device 29 and the evacuation device 12, the evacuation is performed so that the pressure of the film formation chamber 43 is made to be higher than the pressure of the buffer chamber 42 and the pressure of the curing chamber 44 is made to be lower than the pressure of the buffer chamber 42.

When each chamber is to be evacuated, the evacuation is to be performed so that the pressure of the roll chamber 41 becomes higher than the pressure of the buffer chamber 42, and the vapor of the organic compound that has flowed into the buffer chamber 42 from the film formation chamber opening 54 of the film formation chamber 43 is evacuated from the buffer chamber 42 to thereby prevent it from flowing into the curing chamber 44 and the roll chamber 41 from the curing chamber opening 56 and the passing port. A gas-introducing device may be provided in the roll chamber 41 thereby permit an inert gas to be introduced.

A temperature sensor is provided in the interior of the center roller 17, and the control device 29 measures the temperature of the center roller 17 by the temperature sensor; and it is thus possible to control the cooling device 30 so that the temperature of the center roller 17 falls within a prescribed range, and to control the temperature of the base material film 23 when the organic raw material layer 35 is formed and the temperature of the base material film 23 when the organic raw material layer 35 is cured to thereby form the organic thin film 36.

In addition, the control device 29 may control the energy ray-emitting device 16, the neutralization device 28, the vapor generation device 26, or the like.

In the above-described example, motors 37a and 37b are connected to the rotation shaft 18 and the winding device 33, but it may be configured such that the rotation force of the motor assists the rotation of the original material roll 21 by connecting a motor also to the unwinding device 32.

The supply amount of the carrier gas is flow rate-controlled by a mass flow device the carrier gas supply device 27 has and the control device 29 controls; and thus, the grow speed of the organic raw material layer 35 on the base material film 23 can be controlled by the control device 29.

The above-described evacuation device 12 may be provided with a plurality of vacuum pumps and the pressure of each of chambers 41 to 44 may be independently controlled by connecting the independent vacuum pump to each of the chambers 41 to 44.

Furthermore, in the Example, a mask plate 55 is provided in the interior of the curing chamber 44 and the base material film 23 is irradiated with the energy ray having passed through the opening of the mask plate 55, and the base material film 23 located other than the position to be irradiated is prevented from being exposed to the energy ray.

In the neutralization device 28, a set 31 of an electrode for applying a positive voltage and an electrode for applying a negative voltage is disposed and a magnet 38 for shutting in plasma is disposed, in the interior of a housing.

In the above-described monomer, organic compounds capable of being polymerized by the irradiation with an energy ray and capable of forming an organic thin film are widely included.

### Explanation of Reference Numerals

- 11.: vacuum chamber
- 12.: evacuation device
- 14.: rotation axis line
- 17.: center roller
- 19b.: discharge port
- 21.: original material roll
- 23.: base material film
- 26.: vapor generation device
- 27.: carrier gas supply device
- 30.: cooling device
- 32.: unwinding device
- 33.: winding device
- 35.: organic raw material layer
- 36.: organic thin film
- 41.: roll chamber
- 42.: buffer chamber
- 43.: film formation chamber
- 44.: curing chamber
- 54.: film formation chamber opening
- 56.: curing chamber opening

## Claims

1. A thin film formation device, comprising:
a vacuum chamber (11);
a vapor discharge device (19);
an energy ray-emitting device (16);
an unwinding device (32);
a winding device (33); and
a cylindrical center roller (17), wherein an original material roll (21) of a base material film (23) mounted on the unwinding device (32) is unwound, during a time when the unwound base material film (23) runs in the vacuum chamber (11) while a rear surface thereof is in contact with a side surface of the center roller (17) and is wound by the winding device (33), vaporof an organic compound discharged from a discharge port (19b) of the vapor discharge device (19) into the vacuum chamber (11) reaches a surface of the base material film (23) in a portion in contact with the side surface of the center roller (17) to thereby deposit an organic raw material layer (35), then the organic rawmaterial layer (35) is irradiated with an energy ray emitted from an emission part of the energy ray-emitting device (16), and the organic compound in the organic raw material layer (35) chemically reacts to thereby form an organic thin film (36), the thin film formation device, further comprising:
a vapor generation device (26), disposed in the exterior of the vacuum chamber (11), that generates vapor of the organic compound and supplies the vapor to the vapor discharge device (19);
a roll chamber (41) which is disposed in the interior of the vacuum chamber (11) and in which the winding device (33) and the unwinding device (32) are provided;
a buffer chamber (42) disposed in the interior of the vacuum chamber (11) and in the exterior of the roll chamber (41);
a curing chamber (44) disposed in the interior of the buffer chamber (42), wherein the curing chamber (44) is separated from the other section of the interior space of the buffer chamber (42) by a curing chamber partition wall (53),
wherein the other section of the interior space of the buffer chamber (42) is arranged between the curing chamber (44) and the roll chamber (41),
and
a film formation chamber (43) disposed in the interior of the buffer chamber (42);
each of the roll chamber (41), the buffer chamber (42), the film formation chamber (43) and the curing chamber (44) being connected to an evacuation device (12),
the discharge port (19b) being disposed in the interior of the film formation chamber (43),
the emission part being disposed in the curing chamber (44), and
the center roller (17) is disposed so as to rotate around a rotation axis line (14) positioned in the buffer chamber (42),
wherein a film formation chamber (43) opening is provided in a portion positioned between the rotation axis line (14) and the discharge port (19b) in a film formation chamber (43) partition wall forming the film formation chamber (43) and the discharge port (19b) and a side surface of the center roller (17) face each other, and
wherein a curing chamber (44) opening is provided in a portion positioned between the rotation axis line (14) and the emission part in a curing chamber partition wall forming the curing chamber (44), and the emission part and a side surface of the center roller (17) face each other,
a portion of a side surface of the center roller (17), facing the discharge port (19b), is inserted into the interior of the film formation chamber (43) from the film formation chamber opening (54),
a portion of a side wall of the center roller (17), facing the emission part , is inserted into the interior of the curing chamber (44) from the curing chamber opening (56),
wherein the evacuation device (12) is adapted to make the pressure of the film formation chamber (43) higher than pressure of the buffer chamber (42), so that the pressure of the curing chamber (44) is lower than that of the buffer chamber (42).

2. The thin film formation device according to claim 1, wherein a cooling device (30) is connected to the center roller (17), to circulate a cooling medium between the center roller (17) and the cooling device (30), and to cool the center roller (17).

3. The thin film formation device according to any one of claims 1 or 2, further comprising:
a carrier gas supply device (27) for supplying a carrier gas to the vapor generation device (26), wherein
a mixed gas obtained by mixing the carrier gas and vapor of the organic compound is discharged from the discharge port (19b).

## Patentansprüche

1. Dünnfilmbildungsvorrichtung, aufweisend:
eine Vakuumkammer (11);
eine Dampfausstoßvorrichtung (19);
eine energetische Strahlen emittierende Vorrichtung (16);
eine Abwickelvorrichtung (32);
eine Aufwickelvorrichtung (33); und
eine zylindrische Mittelwalze (17), wobei eine Rolle mit Ausgangsmaterial (21) aus einem Film aus Basismaterial (23), der auf der Abwickelvorrichtung (32) befestigt ist, abgewickelt wird, während einer Zeit, in der der abgewickelte Film aus Basismaterial (23) die Vakuumkammer (11) durchläuft, während eine Rückseite davon die Seitenoberfläche der Mittelwalze (17) kontaktiert und von der Aufwickelvorrichtung (33) aufgewickelt wird, wobei Dampf einer organischen Verbindung, der aus einer Ausstoßöffnung (19b) der Dampfausstoßvorrichtung (19) in die Vakuumkammer (11) abgegeben wird, eine Oberfläche des Films aus Basismaterial (23)erreicht in einem Abschnitt, der die Seitenoberfläche der Mittelwalze (17) kontaktiert, um dadurch eine Schicht organischen Ausgangsmaterials (35) abzuscheiden, wonach die Schicht organischen Ausgangsmaterials (35) mit einem Energiestrahl bestrahlt wird, der von einem Emissionsteil der energetische Strahlen emittierenden Vorrichtung (16) emittiert wird, und die organische Verbindung in der Schicht organischen Ausgangsmaterials (35) chemisch reagiert, um dadurch einenorganischen Dünnfilm (36) zu bilden, wobei die Dünnfilmbildungsvorrichtung weiterhin aufweist:
eine außerhalb der Vakuumkammer (11) angeordnete Dampferzeugungsvorrichtung (26), die Dampf der organischen Verbindung erzeugt und den Dampf der Dampfausstoßvorrichtung (19) zuführt;
eine Rollkammer (41), die im Inneren der Vakuumkammer (11) angeordnet ist und in der die Aufwickelvorrichtung (33) und die Abwickelvorrichtung (32) vorgesehen sind;
eine Pufferkammer (42), die im Inneren der Vakuumkammer (11) und außerhalb der Rollkammer (41) angeordnet ist;
eine im Inneren der Pufferkammer (42) angeordnete Härtungskammer (44), wobei die Härtungskammer (44) vom anderen Teil des Innenraumes der Pufferkammer (42) durch eine Härtungskammertrennwand (53) abgeteilt ist,
wobei der andere Teil des Innenraumes der Pufferkammer (42) zwischen der Härtungskammer (44) und der Rollkammer (41) angeordnet ist, und
eine Filmbildungskammer (43), die im Inneren der Pufferkammer (42) angeordnet ist;
wobei sowohl Rollkammer (41), Pufferkammer (42), Filmbildungskammer (43) als auch Härtungskammer (44) mit einer Evakuierungsvorrichtung (12) verbunden sind,
wobei die Ausstoßöffnung (19b) im Inneren der Filmbildungskammer (43) angeordnet ist,
das Emissionsteil in der Härtungskammer (44) angeordnet ist, und
die Mittelwalze (17) so angeordnet ist, dass sie sich um eine Rotationsachsenlinie (14) dreht, die in der Pufferkammer (42) zu liegen kommt,
wobei eine Filmbildungskammertrennwand eine Filmbildungskammeröffnung (54) aufweist, in einem Abschnitt zwischen der Rotationsachsenlinie (14) und der Ausstoßöffnung (19b), welche die Filmbildungskammer (43) und die Ausstoßöffnung (19b) bildet und einer Seitenoberfläche der Mittelwalze (17) gegenüberliegt, und
wobei eine Härtungskammeröffnung (44) in einem Abschnitt vorgesehen ist, der zwischen der Rotationsachsenlinie (14) und dem Emissionsteil in einer die Härtungskammer (44) bildenden Härtungskammertrennwand angeordnet ist, und der Emissionsteil und eine Seitenoberfläche der Mittelwalze (17) einander gegenüberliegen,
ein Abschnitt einer Seitenoberfläche der Mittelwalze (17), der der Ausstoßöffnung (19b) zugewandt ist, in das Innere der Filmbildungskammer (43) von der Filmbildungskammeröffnung (54) aus eingesetzt wird,
ein Abschnitt einer Seitenwand der Mittelwalze (17), der dem Emissionsteil zugewandt ist, von der Härtungskammeröffnung (56) in das Innere der Härtungskammer (44) eingeführt wird,
wobei die Evakuierungsvorrichtung (12) geeignet ist, umdenDruck in der Filmbildungskammer (43) höher als den Druck in der Pufferkammer (42) zu machen, so dass der Druck der Härtungskammer (44) niedriger ist als der in der Pufferkammer (42).

2. Dünnfilmbildungsvorrichtung nach Anspruch 1, wobei eine Kühlvorrichtung (30) mit der Mittelwalze (17) verbunden ist, um ein Kühlmittel zwischen der Mittelwalze (17) und der Kühlvorrichtung (30) zirkulieren zu lassen und die Mittelwalze (17) zu kühlen.

3. Dünnfilmbildungsvorrichtung nach einem der Ansprüche 1 oder 2, ferner aufweisend:
eine Trägergaszuführungsvorrichtung (27) zum Zuführen eines Trägergases zu der Dampferzeugungsvorrichtung (26), wobei
ein Mischgas, das durch Mischen des Trägergases mit dem Dampf der organischen Verbindung erhalten wird, aus der Ausstoßöffnung (19b) ausgelassen wird.

## Revendications

1. Dispositif de formation de film mince, comprenant :
une chambre à vide (11) ;
un dispositif de décharge de vapeur (19) ;
un dispositif d'émission de rayonnement énergétique (16) ;
un dispositif de déroulement (32) ;
un dispositif d'enroulement (33) ; et
un rouleau central cylindrique (17), dans lequel un rouleau de matériau initial (21) d'un film de matériau de base (23) monté sur le dispositif de déroulement (32) est déroulé, pendant un temps pendant lequel le film de matériau de base (23) déroulé se déplace dans la chambre à vide (11) pendant qu'une surface arrière de celui-ci est en contact avec une surface latérale du rouleau central (17) et est enroulé par le dispositif d'enroulement (33), de la vapeur d'un composé organique déchargée depuis un orifice de décharge (19b) du dispositif de décharge de vapeur (19) dans la chambre à vide (11) atteint une surface du film de matériau de base (23) dans une portion en contact avec la surface latérale du rouleau central (17) pour déposer ainsi une couche de matériau organique brut (35), puis la couche de matériau organique brut (35) est irradiée avec un rayonnement énergétique émis depuis une partie émission du dispositif d'émission de rayonnement énergétique (16), et le composé organique dans la couche de matériau organique brut (35) réagit chimiquement pour former ainsi un film mince organique (36), le dispositif de formation de film mince comprenant en outre :
un dispositif de production de vapeur (26), disposé à l'extérieur de la chambre à vide (11), qui produit de la vapeur du composé organique et délivre la vapeur au dispositif de décharge de vapeur (19) ;
une chambre à rouleaux (41) qui est disposée à l'intérieur de la chambre à vide (11) et dans laquelle sont disposés le dispositif d'enroulement (33) et le dispositif de déroulement (32) ;
une chambre tampon (42) disposée à l'intérieur de la chambre à vide (11) et à l'extérieur de la chambre à rouleaux (41) ;
une chambre de durcissement (44) disposée à l'intérieur de la chambre tampon (42), la chambre de durcissement (44) étant séparée de l'autre section de l'espace intérieur de la chambre tampon (42) par une paroi de séparation de chambre de durcissement (53),
l'autre section de l'espace intérieur de la chambre tampon (42) étant disposée entre la chambre de durcissement (44) et la chambre à rouleaux (41), et
une chambre de formation de film (43) disposée à l'intérieur de la chambre tampon (42) ;
la chambre à rouleaux (41), la chambre tampon (42), la chambre de formation de film (43) et la chambre de durcissement (44) étant chacune raccordées à un dispositif d'évacuation (12),
l'orifice de décharge (19b) étant disposé à l'intérieur de la chambre de formation de film (43),
la partie émission étant disposée dans la chambre de durcissement (44), et
le rouleau central (17) est disposé de manière à tourner autour d'un axe de rotation (14) positionné dans la chambre tampon (42),
dans lequel une ouverture de la chambre de formation de film (43) est ménagée dans une portion positionnée entre l'axe de rotation (14) et l'orifice de décharge (19b) dans une paroi de séparation de la chambre de formation de film (43) formant la chambre de formation de film (43), et l'orifice de décharge (19b) et une surface latérale du rouleau central (17) se font face, et
dans lequel une ouverture de la chambre de durcissement (44) est ménagée dans une portion positionnée entre l'axe de rotation (14) et la partie émission dans une paroi de séparation de la chambre de durcissement formant la chambre de durcissement (44), et la partie émission et une surface latérale du rouleau central (17) se font face,
une portion d'une surface latérale du rouleau central (17), faisant face à l'orifice de décharge (19b), est insérée à l'intérieur de la chambre de formation de film (43) depuis l'ouverture (54) de la chambre de formation de film,
une portion d'une paroi latérale du rouleau central (17), faisant face à la partie émission, est insérée à l'intérieur de la chambre de durcissement (44) depuis l'ouverture (56) de la chambre de durcissement,
dans lequel le dispositif d'évacuation (12) est adapté pour rendre la pression de la chambre de formation de film (43) supérieure à la pression de la chambre tampon (42), de telle sorte que la pression de la chambre de durcissement (44) est inférieure à celle de la chambre tampon (42).

2. Dispositif de formation de film mince selon la revendication 1, dans lequel un dispositif de refroidissement (30) est raccordé au rouleau central (17), pour faire circuler un agent réfrigérant entre le rouleau central (17) et le dispositif de refroidissement (30), et pour refroidir le rouleau central (17).

3. Dispositif de formation de film mince selon l'une quelconque des revendications 1 ou 2, comprenant en outre :
un dispositif de délivrance de gaz vecteur (27) pour délivrer un gaz vecteur au dispositif de production de vapeur (26), dans lequel
un gaz mixte obtenu par mélange du gaz vecteur et de la vapeur du composé organique est déchargé depuis l'orifice de décharge (19b).
